# EUROPEAN PATENT APPLICATION

(11) **EP 2 594 970 A1**
(43) Date of publication of application: **22.05.2013**
(21) Application number: 12006884.6
(22) Date of filing: 04.10.2012
(51) Int. Cl.: G02B 5/00, C30B 23/00

(54) **Optical nanoantenna using single-crystalline silver nanowire, method of manufacturing the same and optical nanoantenna using single-crystalline metal nanowire**

(30) Priority: 17.11.2011 KR 20110119947
(71) Applicant: Korea Advanced Institute of Science and Technology, 305-701 Daejeon (KR)
(72) Inventor: Kim, Bong-Soo, Daejeon, 305-701 (KR); Kang, Tae-Joon, Daejeon, 305-701 (KR); Yoon, Il-Sun, Daejeon, 305-701 (KR)
(74) Representative: Sawodny, Michael-Wolfgang

(57) **Abstract**

An optical nanoantenna includes a single-crystalline silver (Ag) nanowire. The single-crystalline silver nanowire is configured to output an optical antenna radiation pattern based on incident lights. The optical antenna radiation pattern includes multilobe radiation patterns, and each multilobe radiation pattern has a plurality of lobes that are radially disposed centered on the single-crystalline silver nanowire. The incident lights are visible lights in entire visible wavelength bands. Accordingly, the optical nanoantenna according to example embodiments operates at multiple resonances in the full visible range.

## Description

### CROSS-REFERENCE TO RELATED APPLICATION

This application claims priority under 35 USC § 119 to Korean Patent Application No. 2011-0119947, filed on November 17, 2011 in the Korean Intellectual Property Office (KIPO), the contents of which are herein incorporated by reference in their entirety.

### BACKGROUND

### 1. Technical Field

Example embodiments relate generally to antennas, and more particularly to optical nanoantennas.

### 2. Description of the Related Art

An optical antenna, as a miniaturization of radio antenna, may convert freely propagating optical radiation into localized fields and vice versa, and may be widely used in the fields of nanosciences. In particular, a plasmonic nanoantenna, which is a kind of an optical nanoantenna, can engineer confinement and absorption of light into specific targets of a nanosize and can control emission properties and even transition lifetimes of fluorescent molecules or photoluminescent quantum dots interfaced with the antenna. Recently, various plasmonic nanoantennas have been researched and developed.

However, a conventional plasmonic nanoantenna, which employs small metallic nanostructures such as bow-ties or nanoparticles, has only a single resonance with a finite spectral width. For optimum interface with the radiation field, a plasmonic nanoantenna may need to play a dual role as a receiver and a transmitter at the same time, for which the operating frequencies can be different. Furthermore, multiwavelength channels may be required in broadband nano-optical spectroscopy as well as in biochemical sensing employing multiple emitters operating at different colors. Accordingly, a plasmonic nanoantenna is required to reliably operate at multiple resonances in the full visible range.

### SUMMARY

Accordingly, the inventive concept is provided to substantially obviate one or more problems due to limitations and disadvantages of the related art.

Some example embodiments provide an optical nanoantenna using a single-crystalline silver nanowire.

Some example embodiments provide a method of manufacturing an optical nanoantenna using a single-crystalline silver nanowire.

Some example embodiments provide an optical nanoantenna using a single-crystalline metal nanowire.

According to example embodiments, an optical nanoantenna includes a single-crystalline silver (Ag) nanowire. The single-crystalline silver nanowire is configured to output an optical antenna radiation pattern based on incident lights. The optical antenna radiation pattern includes multilobe radiation patterns, and each multilobe radiation pattern has a plurality of lobes that are radially disposed centered on the single-crystalline silver nanowire. The incident lights are visible lights in entire visible wavelength bands.

In an example embodiment, the incident lights may include a first light signal having a first wavelength and a second light signal having a second wavelength shorter than the first wavelength. The optical antenna radiation pattern may include a first multilobe radiation pattern emitted based on the first light signal and a second first multilobe radiation pattern emitted based on the second light signal.

A first distance between adjacent two lobes of the plurality of lobes in the first multilobe radiation pattern may be longer than a second distance between adjacent two lobes of the plurality of lobes in the second multilobe radiation pattern.

In an example embodiment, the optical antenna radiation pattern may be generated by converting the incident lights into surface plasmonic polariton (SPP) currents and by reflecting the SPP currents at both ends of the single-crystalline silver nanowire.

In an example embodiment, the single-crystalline silver nanowire may be synthesized by a vapor transportation method.

The single-crystalline silver nanowire may be synthesized by thermally evaporating a silver slug in a furnace to generate a silver vapor, by transporting the silver vapor to a single-crystalline substrate using an inert gas, and by growing the single-crystalline silver nanowire on the single-crystalline substrate, and wherein the single-crystalline substrate is located in the furnace and has a temperature lower than a temperature of the silver slug.

According to example embodiments, in a method of manufacturing an optical nanoantenna including a single-crystalline silver (Ag) nanowire, a silver slug is thermally evaporated in a furnace to generate a silver vapor. The silver vapor is transported to a single-crystalline substrate using an inert gas. The single-crystalline substrate is located in the furnace and has a temperature lower than a temperature of the silver slug. The single-crystalline silver nanowire is grown on the single-crystalline substrate. The single-crystalline silver nanowire outputs an optical antenna radiation pattern based on incident lights. The optical antenna radiation pattern includes multilobe radiation patterns, and each multilobe radiation pattern has a plurality of lobes that are radially disposed centered on the single-crystalline silver nanowire. The incident lights are visible lights in entire visible wavelength bands.

In an example embodiment, the single-crystalline silver nanowire may have a face-centered cubic structure and may be grown in a [110] crystalline direction.

According to example embodiments, an optical nanoantenna includes a single-crystalline silver (Ag) nanowire. The single-crystalline silver nanowire is configured to output an optical antenna radiation pattern based on incident lights. The optical antenna radiation pattern includes multilobe radiation patterns, and each multilobe radiation pattern has a plurality of lobes that are radially disposed centered on the single-crystalline silver nanowire. The incident lights include infrared lights in entire infrared wavelength bands, visible lights in entire visible wavelength bands, and ultraviolet lights in entire ultraviolet wavelength bands.

In an example embodiment, the incident lights may include a first light signal having a first wavelength and a second light signal having a second wavelength shorter than the first wavelength. The optical antenna radiation pattern may include a first multilobe radiation pattern emitted based on the first light signal and a second first multilobe radiation pattern emitted based on the second light signal.

A first distance between adjacent two lobes of the plurality of lobes in the first multilobe radiation pattern may be longer than a second distance between adjacent two lobes of the plurality of lobes in the second multilobe radiation pattern.

According to example embodiments, an optical nanoantenna includes a single-crystalline metal nanowire. The single-crystalline metal nanowire is configured to output an optical antenna radiation pattern based on incident lights. The optical antenna radiation pattern includes multilobe radiation patterns, and each multilobe radiation pattern has a plurality of lobes that are radially disposed centered on the single-crystalline metal nanowire. The incident lights are visible lights in entire visible wavelength bands.

In an example embodiment, the incident lights may include a first light signal having a first wavelength and a second light signal having a second wavelength shorter than the first wavelength. The optical antenna radiation pattern may include a first multilobe radiation pattern emitted based on the first light signal and a second first multilobe radiation pattern emitted based on the second light signal.

A first distance between adjacent two lobes of the plurality of lobes in the first multilobe radiation pattern may be longer than a second distance between adjacent two lobes of the plurality of lobes in the second multilobe radiation pattern.

In an example embodiment, the single-crystalline metal nanowire may be synthesized using gold (Au), platinum (Pt), palladium (Pd) or aluminum (Al).

Accordingly, the optical nanoantenna according to example embodiments may output the multilobe-shaped optical antenna radiation patterns, may operate at multiple resonances in the full visible range. The optical nanoantenna according to example embodiments may efficiently transmit and receive optical signals.

### BRIEF DESCRIPTION OF THE DRAWINGS

Illustrative, non-limiting example embodiments will be more clearly understood from the following detailed description taken in conjunction with the accompanying drawings.

FIG. 1 is a diagram for describing a method of manufacturing a single-crystalline silver nanowire included in an optical nanoantenna according to example embodiments.

FIGS. 2A, 2B and 2C are diagrams illustrating the single-crystalline silver nanowire which is manufactured by the method explained with reference to FIG. 1.

FIGS. 3A, 3B, 3C, 3D and 3E are diagrams illustrating the optical nanoantenna according to example embodiments.

FIG. 4 is a diagram describing a method of measuring an optical antenna radiation pattern from the optical nanoantenna according to example embodiments.

FIGS. 5A and 5B are diagrams illustrating optical antenna radiation patterns from the optical nanoantenna according to example embodiments.

FIGS. 6A and 6B are diagrams illustrating simulation results of the optical nanoantenna according to example embodiments.

FIG. 7 is a diagram illustrating the optical antenna radiation pattern from the optical nanoantenna according to example embodiments.

### DETAILED DESCRIPTION OF THE EMBODIMENTS

Various example embodiments will be described more fully with reference to the accompanying drawings, in which embodiments are shown. This inventive concept may, however, be embodied in many different forms and should not be construed as limited to the embodiments set forth herein. Rather, these embodiments are provided so that this disclosure will be thorough and complete, and will fully convey the scope of the inventive concept to those skilled in the art. Like reference numerals refer to like elements throughout this application.

It will be understood that, although the terms first, second, etc. may be used herein to describe various elements, these elements should not be limited by these terms. These terms are used to distinguish one element from another. For example, a first element could be termed a second element, and, similarly, a second element could be termed a first element, without departing from the scope of the inventive concept. As used herein, the term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments and is not intended to be limiting of the inventive concept. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements, and/or components, but do not preclude the presence or addition of one or more other.

Unless otherwise defined, all terms (including technical and scientific terms) used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

An optical nanoantenna according to example embodiments may be implemented using a single-crystalline silver (Ag) nanowire. The silver has no interband electronic transition at visible wavelength bands (e.g. from about 430 nm to about 700 nm), and a sufficiently long metal nanowire may support multiple surface plasmon polariton (SPP) resonances in a relatively wide spectral range. Thus, the optical nanoantenna using a silver nanowire may operate at multiple resonances in the full visible range.

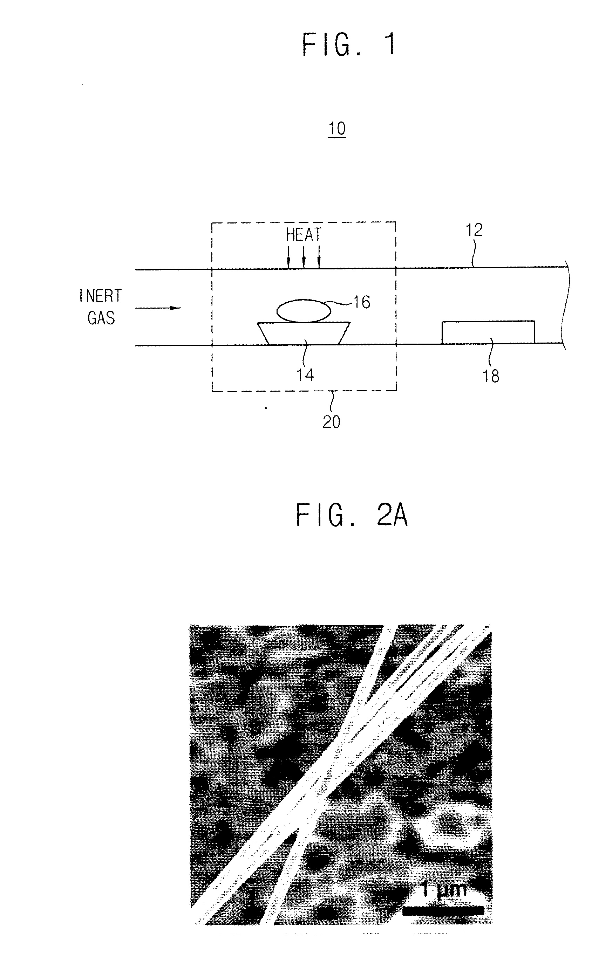

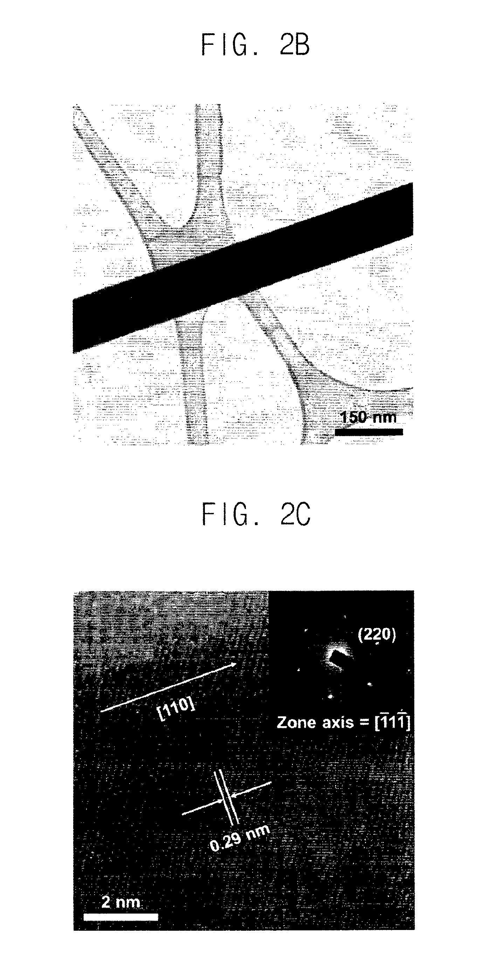

A silver nanowire synthesized by a conventional method has a relatively rough surface, and performances of the optical nanoantenna implemented using the conventional silver nanowire may be degraded due to the relatively rough surface. As described later with reference to FIGS. 1, 2A, 2B and 2C, the optical nanoantenna according to example embodiments may be implemented using the single-crystalline silver nanowire that is synthesized by a vapor transportation method and has a relatively smooth surface.

Hereinafter, the optical nanoantenna according to example embodiments will be described based on the single-crystalline silver nanowire. However, the optical nanoantenna according to example embodiments may be implemented using a single-crystalline metal nanowire that is synthesized using at least one of various metals. For example, the single-crystalline metal nanowire may be synthesized using gold (Au), platinum (Pt), palladium (Pd) or aluminum (Al).

FIG. 1 is a diagram for describing a method of manufacturing a single-crystalline silver nanowire included in an optical nanoantenna according to example embodiments.

Referring to FIG. 1, the single-crystalline silver nanowire may be synthesized by a vapor transportation method. A furnace 10, which is used to synthesize the single-crystalline silver nanowire, may include a quartz tube 12, an alumina boat 14 and a single-crystalline substrate 18.

The quartz tube 12 may be horizontally disposed with respect to the ground. For example, the quartz tube 12 may have a diameter of about 1 inch. The alumina boat 14 may be disposed at a front part of the quartz tube 12. A precursor, e.g., a silver slug 16, may be inserted in the quartz tube 12 using the alumina boat 14. The single-crystalline substrate 18, e.g., a sapphire substrate, may be disposed at a back part of the quartz tube 12. The single-crystalline silver nanowire may be generated on the single-crystalline substrate 18. An inert gas, e.g., an argon (Ar) gas, may be injected into the front part of the quartz tube 12, may flow through the quartz tube 12, and may be exhausted from the back part of the quartz tube 12. Although not illustrated in FIG. 1, the furnace 10 may further include a vacuum pump, a heater and/or a temperature regulator.

The single-crystalline silver nanowire may be synthesized by thermally evaporating the precursor (e.g., the silver slug 16) in the furnace 10 to generate a silver vapor, by transporting the silver vapor to the single-crystalline substrate 18 using the inert gas, and by growing the single-crystalline silver nanowire on the single-crystalline substrate 18. The single-crystalline substrate 18 may have a temperature lower than a temperature of the silver slug 16. For example, a heating zone 20 in the furnace 10 may be heated to a temperature of about 800 °C, the inert gas may flow through the quartz tube 12 at about 100 sccm, a distance between the alumina boat 14 and the single-crystalline substrate 18 may be about 5cm, a pressure in the furnace 10 may be about 5 to 15 torr, and a reaction time may be about 30 minutes.

FIGS. 2A, 2B and 2C are diagrams illustrating the single-crystalline silver nanowire which is manufactured by the method explained with reference to FIG. 1. FIG. 2A is a scanning electron microscope (SEM) image of the single-crystalline silver nanowire. FIG. 2B is a low resolution transmission electron microscope (TEM) image of the single-crystalline silver nanowire. FIG. 2C is a high resolution TEM image and a selected area electron diffraction (SAED) pattern of the single-crystalline silver nanowire.

Referring to FIG. 2A, the single-crystalline silver nanowires have round-shaped tips, diameters of about 100-200 nm, and lengths of a few or tens of micrometers. Referring to FIGS. 2B and 2C, the single-crystalline silver nanowire has a face-centered cubic (FCC) structure and is grown in a [110] crystalline direction. As illustrated in FIGS. 2A, 2B and 2C, the single-crystalline silver nanowires have relatively smooth surfaces, which are referred to as defect-free silver nanowires. For example, the defect-free silver nanowires fabricated by the method explained with reference to FIG. 1 have atomically flat and well-defined surfaces (e.g., ultra-smooth surfaces), whereas silver nanowires fabricated by conventional top-down techniques are accompanied by roughness of a few nanometers or more.

Because surface plasmons exist very close to a metal/dielectric interface, SPP propagation at the metal/dielectric interface is improved as the metal/dielectric surface becomes smooth. The metal or dielectric with the single-crystalline structure has an electrical conductivity higher than an electrical conductivity of the metal or dielectric with the poly-crystalline structure. Moreover, scattering loss gets higher at the shorter wavelength. Accordingly, the optical nanoantenna using the single-crystalline silver nanowire may support the SPP propagation without the scattering loss and may operate in the full visible range.

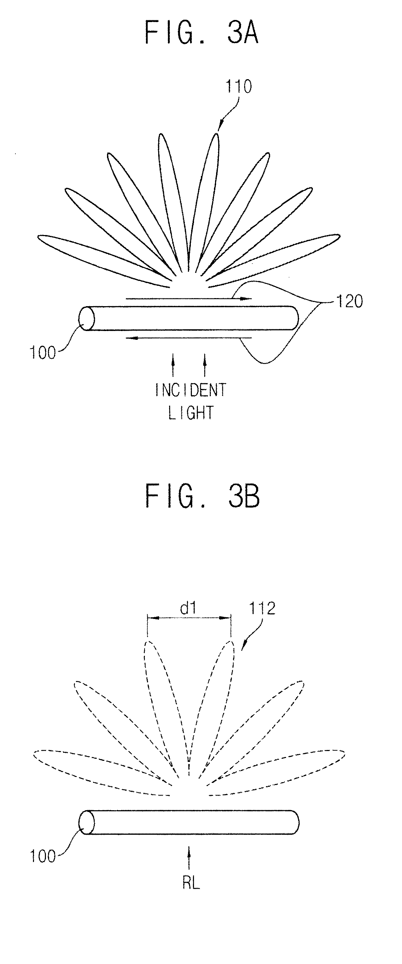

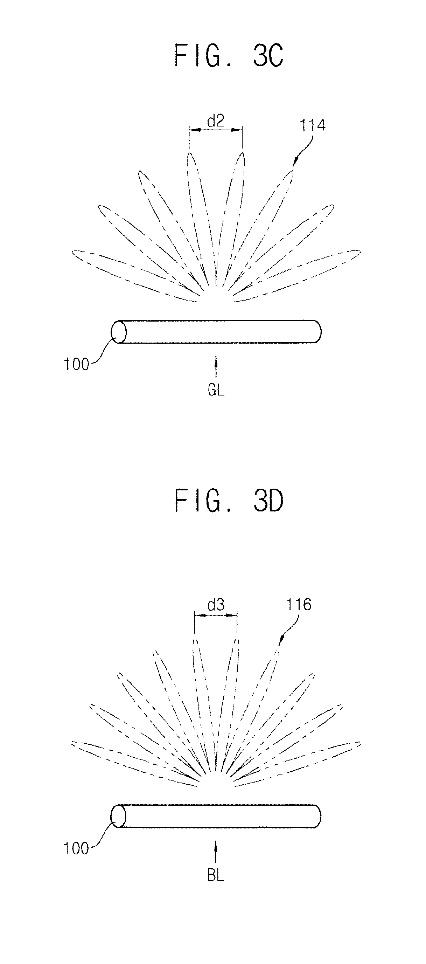

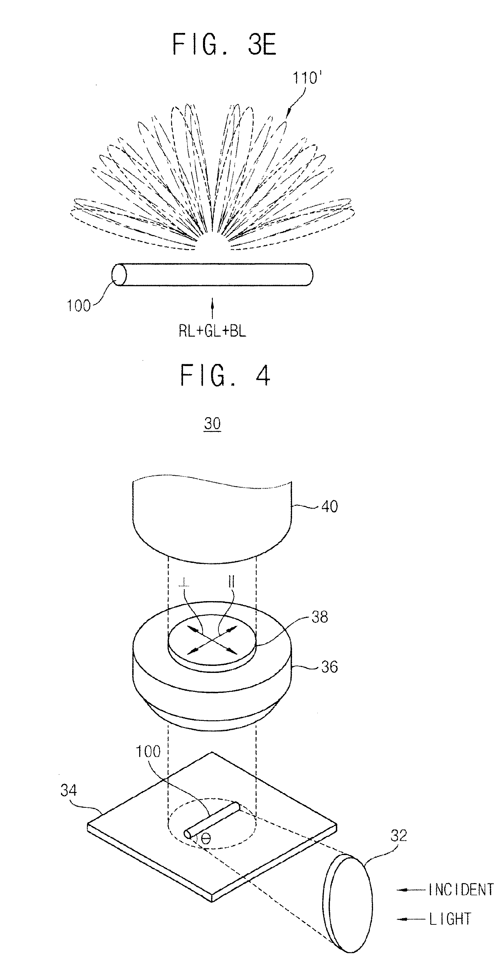

FIGS. 3A, 3B, 3C, 3D and 3E are diagrams illustrating the optical nanoantenna according to example embodiments.

Referring to FIG. 3A, the optical nanoantenna includes the single-crystalline silver nanowire 100. The single-crystalline silver nanowire 100 outputs an optical antenna radiation pattern 110 based on incident lights. The incident lights include visible lights in entire visible wavelength bands. As illustrated in FIG. 3A, the optical antenna radiation pattern 110 has a plurality of lobes that are radially (e.g., semicircular radially) disposed centered on the single-crystalline silver nanowire 100, which is referred to as multilobe shaped.

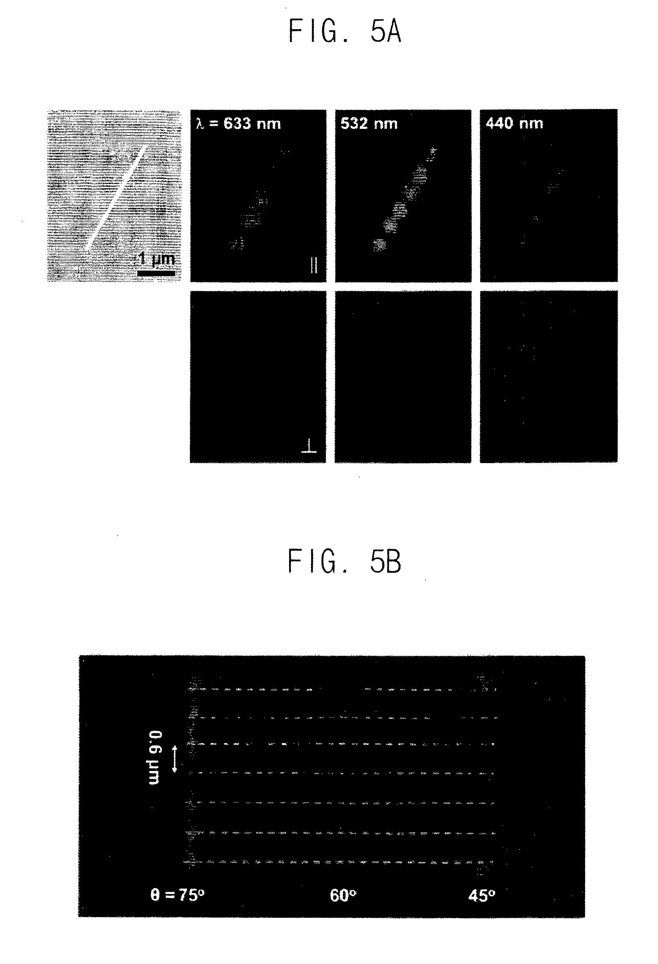

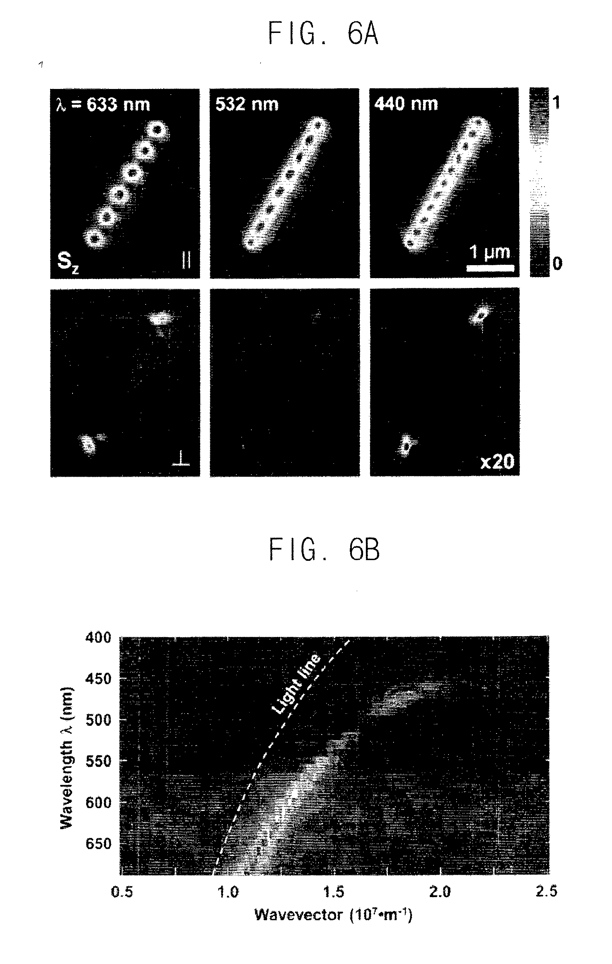

The optical antenna radiation pattern 110 may be generated by converting the incident lights into charge density waves (CDWs), e.g., SPP currents 120, and by reflecting the SPP currents 120 at both ends of the single-crystalline silver nanowire 100. In other words, the incident light excites the SPP currents 120, which propagate back and forth along a surface of the single-crystalline silver nanowire 100 by reflecting at both ends of the single-crystalline silver nanowire 100. According to the antenna theory, the SPP currents 120 propagating toward both ends of the single-crystalline silver nanowire 100 form a standing wave in time-harmonic motion, and time-varying currents of charges in the single-crystalline silver nanowire 100 create radiations, even if the single-crystalline silver nanowire 100 is straight. Therefore, unique multilobe radiation patterns may be generated and observed by SPP standing currents on the single-crystalline silver nanowire 100. Because the charge-density waves (e.g., the SPP currents 120) are generated along the surface of the single-crystalline silver nanowire 100, the polarization of the optical antenna radiation pattern 110 may be parallel to the long axis of the single-crystalline silver nanowire 100, as described later with reference to FIGS. 5A and 6A. For example, if the single-crystalline silver nanowire 100 is column shaped, the long axis of the single-crystalline silver nanowire 100 may be an axis of the column.

Referring to FIGS. 3B, 3C, 3D and 3E, the incident lights may include a first light signal having a first wavelength and a second light signal having a second wavelength shorter than the first wavelength. For example, the first light signal may be a red light RL, and the second light signal may be a green light GL or a blue light BL. For another example, the first light signal may be the green light GL, and the second light signal may be the blue light BL. According to example embodiments, the incident lights may further include a third light signal having a third wavelength shorter than the second wavelength. For example, the first light signal may be the red light RL, the second light signal may be the green light GL, and the third light signal may be the blue light BL. The red light RL may have a wavelength of about 632.8 nm, the green light GL may have a wavelength of about 532 nm, and the blue light BL may have a wavelength of about 440 nm.

The optical antenna radiation pattern 110' includes multilobe radiation patterns 112, 114 and 116. Each multilobe radiation pattern has a plurality of lobes that are radially disposed centered on the single-crystalline silver nanowire 100. For example, the optical antenna radiation pattern 110' may include a first multilobe radiation pattern emitted based on the first light signal and a second first multilobe radiation pattern emitted based on the second light signal. A first distance between adjacent two lobes of the plurality of lobes in the first multilobe radiation pattern may be longer than a second distance between adjacent two lobes of the plurality of lobes in the second multilobe radiation pattern. In other words, a distance between adjacent two lobes in a single multilobe radiation pattern may be short as a wavelength of a light signal corresponding the single multilobe radiation pattern becomes short.

For example, a distance d1 between adjacent two lobes (e.g., two red lobes) in a multilobe radiation pattern 112 emitted based on the red light RL may be longer than a distance d2 between adjacent two lobes (e.g., two green lobes) in a multilobe radiation pattern 114 emitted based on the green light GL. The distance d2 between adjacent two lobes (e.g., two green lobes) in the multilobe radiation pattern 114 emitted based on the green light GL may be longer than a distance d3 between adjacent two lobes (e.g., two blue lobes) in a multilobe radiation pattern 116 emitted based on the blue light BL.

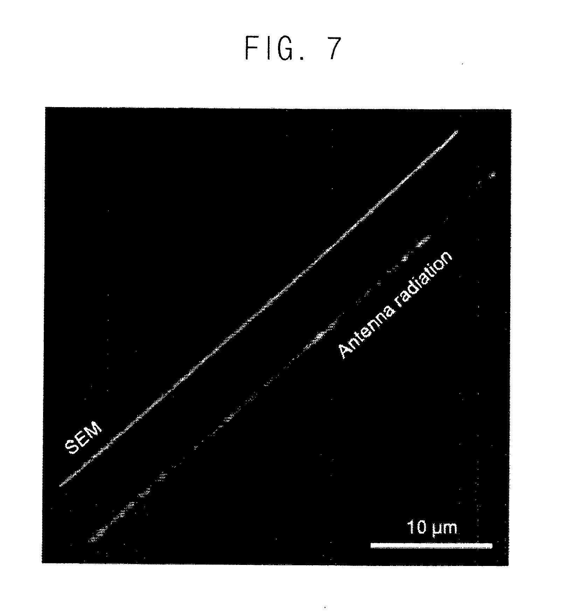

The optical nanoantenna according to example embodiments may output the optical antenna radiation pattern from the single-crystalline silver nanowire 100 based on the visible lights in the entire visible wavelength bands. Accordingly, as illustrated in FIG. 3E, when the single-crystalline silver nanowire 100 receives the white light including the red light RL, the green light GL and the blue light BL, the single-crystalline silver nanowire 100 may output the optical antenna radiation pattern 110' such that the multilobe radiation patterns 112, 114 and 116 included in the optical antenna radiation pattern 110' are overlapped. In this case, the colorful optical antenna radiation pattern like a rainbow may be observed as illustrated in FIG. 7.

Although FIGS. 3B, 3C, 3D and 3E illustrates the incident lights including the red light RL, the green light GL and the blue light BL, the number and colors of the light signals included in the incident lights are not limited thereto.

FIG. 4 is a diagram describing a method of measuring an optical antenna radiation pattern from the optical nanoantenna according to example embodiments.

Referring to FIG. 4, a device 30 for measuring an optical antenna radiation pattern from the optical nanoantenna using the single-crystalline silver nanowire 100 includes a lens 32, a glass substrate 34, an objective lens 36, a linear polarizer 38 and a charge-coupled device (CCD) camera 40.

The single-crystalline silver nanowire 100 included in the optical nanoantenna may be placed on the glass substrate 34. The incident lights may be provided from a white light source or a laser source having a specific color, and may be concentrated by the lens 32. The incident lights concentrated by the lens 32 may be injected into the single-crystalline silver nanowire 100 at an angle θ of about 80° with respect to the normal direction of glass substrate 34. The objective lens 36 may be a dry type objective lens, and may have a magnification of about 1000 and a numerical aperture (NA) of about 0.7. When the incident angle (e.g., about 80°) of light is greater than the angle of the numerical aperture of the objective lens 36, an environment of a dark-field optical microscope may be set up, the SPP antenna radiation may be separated from light that is directly reflected by the glass substrate 34, and thus only the SPP antenna radiation (e.g., the optical antenna radiation pattern) may be detected. The linear polarizer 38 on the objective lens 36 may determine the polarization states of the optical antenna radiation pattern. The radiation patterns may be measured by CCD camera 40 with respect to a first direction "∥" parallel to the single-crystalline silver nanowire 100 and a second direction "⊥" perpendicular to the single-crystalline silver nanowire 100.

FIGS. 5A and 5B are diagrams illustrating optical antenna radiation patterns from the optical nanoantenna according to example embodiments. FIGS. 5A and 5B illustrate the measurement results of the optical antenna radiation pattern from the single-crystalline silver nanowire based on the device 30 of FIG. 4.

Referring to FIG. 5A, to investigate the operation wavelength range of the optical nanoantenna using the single-crystalline silver nanowire, the optical antenna radiation patterns may be measured based on the red light having a wavelength of about 633 nm, the green light having a wavelength of about 532 nm and the blue light having a wavelength of about 440 nm. An image at the top left-hand corner in FIG. 5A is an optical micrograph of the optical nanoantenna using the single-crystalline silver nanowire that is synthesized by the method explained with reference to FIG. 1. The single-crystalline silver nanowire may have a length of about 3.1µm and a diameter of about 150 nm. Three images at the top in FIG. 5A are the optical antenna radiation patterns that are measured with respect to the first direction "∥." Three images at the bottom in FIG. 5A are patterns that are measured with respect to the second direction "⊥."

Although some patterns are blurredly measured due to the numerical aperture and limited resolution of the objective lens 36 in FIG. 4, the multilobe-shaped optical antenna radiation patterns may be observed based on the red, green and blue lights, respectively. The optical antenna radiation patterns may have a plurality of lobes that are uniformly distributed, as described above with reference to FIGS. 3A, 3B, 3C, 3D and 3E. In addition, the optical antenna radiation patterns may be polarized in parallel with the long axis of the single-crystalline silver nanowire. In other words, the multilobe-shaped optical antenna radiation patterns are clearly detected with respect to the first direction "∥," and are not detected with respect to the second direction "⊥." The incident light has parallel polarization to the incident plane, which can reduce light reflection from the substrate more than perpendicular polarization at an angle moderately greater than the Brewster angle, improving the visibility of SPP antenna radiation against a background noise.

A distance between adjacent two lobes in a single multilobe radiation pattern may be short as a wavelength of a light signal corresponding the single multilobe radiation pattern becomes short. For example, a distance between adjacent two red lobes (e.g., adjacent two lobes in the multilobe radiation pattern emitted based on the red light having the wavelength of about 633 nm) may be about 600 nm. A distance between adjacent two green lobes (e.g., adjacent two lobes in the multilobe radiation pattern emitted based on the green light having the wavelength of about 532 nm) may be about 510 nm. A distance between adjacent two blue lobes (e.g., adjacent two lobes in the multilobe radiation pattern emitted based on the blue light having the wavelength of about 440 nm) may be about 420 nm. The distances between adjacent two lobes are shorter than the free-space light wavelengths, reflecting the sub-wavelength-scale properties of the SPP antenna modes.

Referring to FIG. 5B, the multilobe-shaped optical antenna radiation patterns may be independent of the incident angle (e.g., the angle θ in FIG. 4) of the light. For example, when the optical antenna radiation pattern is generated based on the red light, the distance between adjacent two red lobes may be maintained at about 600 nm (i.e., about 0.6µm), although the incident angle of light is changed into 75°, 60°, 45°, respectively. This strongly indicates that the optical antenna radiation patterns is not originated from the diffracted light, but originated from the SPP currents on the single-crystalline silver nanowire.

As described above with reference to FIGS. 5A and 5B, the optical nanoantenna using the single-crystalline silver nanowire may have the incident electric fields have both parallel and perpendicular components with respect to the long axis of the single-crystalline silver nanowire and may convert the currents (e.g., the SPP currents) into the visible antenna radiation patterns. Accordingly, the single-crystalline silver nanowire may efficiently transmit and receive optical signals.

FIGS. 6A and 6B are diagrams illustrating simulation results of the optical nanoantenna according to example embodiments.

Referring to FIG. 6A, full-field electromagnetic simulations are performed based on the 3-dimensional (3-D) finite-difference time-domain (FDTD) method. FIG. 6A illustrates the vertical component distributions of the poynting vectors of the optical antenna radiation patterns at different free-space light wavelengths, based on the red light having the wavelength of about 633 nm, the green light having the wavelength of about 532 nm and the blue light having the wavelength of about 440 nm. The length and the diameter of the single-crystalline silver nanowire are set to about 3.1µm and about 150 nm, respectively. The SPP currents are induced by injecting a plane wave at the incident angle of 80°. It is assumed that the single-crystalline silver nanowire is surrounded by air and the glass substrate mostly influences spectral positions of the antenna resonances rather than their field distributions. The calculated poynting vector distributions are captured at a plane 150 nm above the single-crystalline silver nanowire.

Similarly to FIG. 5A, it is checked based on the simulation results in FIG. 6A that the multilobe-shaped optical antenna radiation patterns are observed based on the red, green and blue lights, respectively, the optical antenna radiation patterns may be polarized in parallel with the long axis of the single-crystalline silver nanowire, and a distance between adjacent two lobes in a single multilobe radiation pattern is short as a wavelength of a light signal corresponding the single multilobe radiation pattern becomes short. In the simulation results in FIG. 6A, a distance between adjacent two red lobes may be about 520 nm, a distance between adjacent two green lobes may be about 420 nm, and a distance between adjacent two blue lobes may be about 290 nm. The discrepancies between the theoretically predicted distances (e.g., 520, 420, 290 nm) in FIG. 6A and the experimentally measured distances (e.g., 600, 510, 420 nm) in FIG. 5A are due to expansion of the lobes and their spacings in proportion to the distance from the single-crystalline silver nanowire to the measurement plane (e.g., the focal plane). The obtained distances between adjacent two lobes may correspond to the wavelength of the SPP currents propagating along the single-crystalline silver nanowire. FIG. 6B illustrates the dispersion curve of the SPP currents propagating along the single-crystalline silver nanowire.

As described with reference to FIGS. 5A, 5B, 6A and 6B, the characteristics of the optical nanoantenna using the single-crystalline silver nanowire, such as the shape and polarization of the optical antenna radiation pattern, may be verified based on the measurement results and the simulation results.

FIG. 7 is a diagram illustrating the optical antenna radiation pattern from the optical nanoantenna according to example embodiments. FIG. 7 illustrates the measurement result of the optical antenna radiation pattern from the single-crystalline silver nanowire placed on a silver film, instead of a glass substrate. The silver film may operate as a mirror to reflect the optical antenna radiation pattern, and thus the optical antenna radiation pattern may be more easily detected.

Referring to FIG. 7, the optical antenna radiation patterns may be measured based on a white light in entire visible wavelength bands. The single-crystalline silver nanowire may have a length of about 41µm and a diameter of about 180 nm. In FIG. 7, the multilobe-shaped optical antenna radiation patterns may be observed even though the length of the single-crystalline silver nanowire is sufficiently long. Particularly, the colorful optical antenna radiation pattern like a rainbow may be observed.

As described above, as the 1-dimensional (1-D) SPP cavity, the optical nanoantenna using the single-crystalline silver nanowire supports its resonance modes by reflecting the SPP currents at both ends of the single-crystalline silver nanowire. The propagation wavelength of the SPP currents, e.g., λSPP, in the cavity are given by the waveguide modes of the single-crystalline silver nanowire, which depends on a diameter of the single-crystalline silver nanowire. The resonance condition of the optical nanoantenna using the single-crystalline silver nanowire is determined by a length of the single-crystalline silver nanowire, which is slightly shifted from the multiples of λSPP/2, because the ends of the single-crystalline silver nanowire are not rigid mirrors. In a sufficiently long optical nanoantenna, several resonance modes can exist over the full visible frequency range. When the SPP currents are excited by a white light source, distinct conditions for each resonance make radiating near-field lobes appear at different locations of the single-crystalline silver nanowire. Accordingly, the single-crystalline silver nanowire may output the optical antenna radiation pattern such that the multilobe radiation patterns emitted based on various visible lights are overlapped, as illustrated in FIG. 3E. In addition, the colorful optical antenna radiation pattern like a rainbow may be observed, as illustrated in FIG. 7.

Although the optical nanoantenna according to example embodiments is mainly described to operate based on the visible lights, the optical nanoantenna may operate based on the incident lights including infrared lights, the visible lights and ultraviolet lights. In other words, the optical nanoantenna according to example embodiments includes a single-crystalline silver nanowire configured to output an optical antenna radiation pattern based on incident lights. The incident lights include the infrared lights in entire infrared wavelength bands, the visible lights in entire visible wavelength bands, and the ultraviolet lights in entire ultraviolet wavelength bands. The optical antenna radiation pattern includes multilobe radiation patterns, and each multilobe radiation pattern has a plurality of lobes that are radially disposed centered on the single-crystalline silver nanowire. In this embodiment, as described with reference to FIG. 3A, 3B, 3C, 3D and 3E, the incident lights may include a first light signal having a first wavelength and a second light signal having a second wavelength shorter than the first wavelength. The optical antenna radiation pattern may include a first multilobe radiation pattern emitted based on the first light signal and a second first multilobe radiation pattern emitted based on the second light signal. A first distance between adjacent two lobes of the plurality of lobes in the first multilobe radiation pattern may be longer than a second distance between adjacent two lobes of the plurality of lobes in the second multilobe radiation pattern.

Although the optical nanoantenna according to example embodiments is mainly described to include the single-crystalline silver nanowire, the optical nanoantenna may include a single-crystalline metal nanowire that is synthesized using at least one of various metals, such as gold (Au), platinum (Pt), palladium (Pd) or aluminum (Al).

The above described embodiments may be applied to a device and an electronic system having the optical nanoantenna. For example, the above described embodiments may be applied to applications in nano-optical spectroscopy, high-resolution nanoimaging, photovoltaics, and nonlinear signal conversion.

The foregoing is illustrative of example embodiments and is not to be construed as limiting thereof. Although a few example embodiments have been described, those skilled in the art will readily appreciate that many modifications are possible in the example embodiments without materially departing from the novel teachings and advantages of the present inventive concept. Accordingly, all such modifications are intended to be included within the scope of the present inventive concept as defined in the claims. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. An optical nanoantenna, comprising:
a single-crystalline silver (Ag) nanowire configured to output an optical antenna radiation pattern based on incident lights, wherein the optical antenna radiation pattern includes multilobe radiation patterns, wherein each multilobe radiation pattern has a plurality of lobes that are radially disposed centered on the single-crystalline silver nanowire, and wherein the incident lights are visible lights in entire visible wavelength bands.

2. The optical nanoantenna of claim 1, wherein the incident lights include a first light signal having a first wavelength and a second light signal having a second wavelength shorter than the first wavelength, and
wherein the optical antenna radiation pattern includes a first multilobe radiation pattern emitted based on the first light signal and a second first multilobe radiation pattern emitted based on the second light signal.

3. The optical nanoantenna claim 2, wherein a first distance between adjacent two lobes of the plurality of lobes in the first multilobe radiation pattern is longer than a second distance between adjacent two lobes of the plurality of lobes in the second multilobe radiation pattern.

4. The optical nanoantenna of claim 1, wherein the optical antenna radiation pattern is generated by converting the incident lights into surface plasmonic polariton (SPP) currents and by reflecting the SPP currents at both ends of the single-crystalline silver nanowire.

5. The optical nanoantenna of claim 1, wherein the single-crystalline silver nanowire is synthesized by a vapor transportation method.

6. The optical nanoantenna of claim 5, wherein the single-crystalline silver nanowire is synthesized by thermally evaporating a silver slug in a furnace to generate a silver vapor, by transporting the silver vapor to a single-crystalline substrate using an inert gas, and by growing the single-crystalline silver nanowire on the single-crystalline substrate, and wherein the single-crystalline substrate is located in the furnace and has a temperature lower than a temperature of the silver slug.

7. A method of manufacturing an optical nanoantenna including a single-crystalline silver (Ag) nanowire, the method comprising:
thermally evaporating a silver slug in a furnace to generate a silver vapor;
transporting the silver vapor to a single-crystalline substrate using an inert gas, wherein the single-crystalline substrate is located in the furnace and has a temperature lower than a temperature of the silver slug; and
growing the single-crystalline silver nanowire on the single-crystalline substrate,
wherein the single-crystalline silver nanowire outputs an optical antenna radiation pattern based on incident lights, wherein the optical antenna radiation pattern includes multilobe radiation patterns, wherein each multilobe radiation pattern has a plurality of lobes that are radially disposed centered on the single-crystalline silver nanowire, and wherein the incident lights are visible lights in entire visible wavelength bands.

8. The method of claim 7, wherein the single-crystalline silver nanowire has a face-centered cubic structure and is grown in a [110] crystalline direction.

9. An optical nanoantenna, comprising:
a single-crystalline silver (Ag) nanowire configured to output an optical antenna radiation pattern based on incident lights, wherein the optical antenna radiation pattern includes multilobe radiation patterns, wherein each multilobe radiation pattern has a plurality of lobes that are radially disposed centered on the single-crystalline silver nanowire, and wherein the incident lights include infrared lights in entire infrared wavelength bands, visible lights in entire visible wavelength bands, and ultraviolet lights in entire ultraviolet wavelength bands.

10. The optical nanoantenna of claim 9, wherein the incident lights include a first light signal having a first wavelength and a second light signal having a second wavelength shorter than the first wavelength, and
wherein the optical antenna radiation pattern includes a first multilobe radiation pattern emitted based on the first light signal and a second first multilobe radiation pattern emitted based on the second light signal.

11. The optical nanoantenna claim 10, wherein a first distance between adjacent two lobes of the plurality of lobes in the first multilobe radiation pattern is longer than a second distance between adjacent two lobes of the plurality of lobes in the second multilobe radiation pattern.

12. An optical nanoantenna, comprising:
a single-crystalline metal nanowire configured to output an optical antenna radiation pattern based on incident lights, wherein the optical antenna radiation pattern includes multilobe radiation patterns, wherein each multilobe radiation pattern has a plurality of lobes that are radially disposed centered on the single-crystalline metal nanowire, and wherein the incident lights are visible lights in entire visible wavelength bands.

13. The optical nanoantenna of claim 12, wherein the incident lights include a first light signal having a first wavelength and a second light signal having a second wavelength shorter than the first wavelength, and
wherein the optical antenna radiation pattern includes a first multilobe radiation pattern emitted based on the first light signal and a second first multilobe radiation pattern emitted based on the second light signal.

14. The optical nanoantenna claim 13, wherein a first distance between adjacent two lobes of the plurality of lobes in the first multilobe radiation pattern is longer than a second distance between adjacent two lobes of the plurality of lobes in the second multilobe radiation pattern.

15. The optical nanoantenna of claim 12, wherein the single-crystalline metal nanowire is synthesized using gold (Au), platinum (Pt), palladium (Pd) or aluminum (Al).
